# EUROPEAN PATENT APPLICATION

(11) **EP 4 761 114 A2**
(43) Date of publication of application: **17.06.2026**
(21) Application number: 25221785.6
(22) Date of filing: 09.12.2025
(51) Int. Cl.: H03K 19/003, H03K 19/0185

(54) **SYSTEM AND METHOD TO HANDLE I/O CELL CURRENT INJECTION FAULTS**

(30) Priority: 16.12.2024 US 202418982641
(71) Applicant: NXP USA, Inc., Austin, TX 78735 (US)
(72) Inventor: Vilas Boas, Andre Luis, 5656AG Eindhoven (NL); Dao, Chris C., 5656AG Eindhoven (NL); Micielli, Christopher, 5656AG Eindhoven (NL); Sanchez, Hector, 5656AG Eindhoven (NL); Stockinger, Michael A., 5656AG Eindhoven (NL)
(74) Representative: Schwarzweller, Thomas

(57) **Abstract**

An integrated circuit is provided with a signal node/IO pad in an output buffer that is protected by a current injection protection circuit which includes first and second comparators connected between a first voltage supply and a second voltage supply to generate first and second control signals in response to, respectively, a positive or negative injected current at the signal node, and which also includes a pre-driver stack of transistors which generate, respectively, a positive gate control signal and negative gate control signal, and which also includes a multiplex selection circuit connected to output the positive gate control signal and negative gate control signal to the output buffer to clamp signal node to a first clamped voltage if a voltage on the signal node exceeds the first supply voltage or to a second clamped voltage if a voltage on the signal node falls below the second supply voltage.

## Description

### BACKGROUND

### Field

The present disclosure is directed in general to integrated circuits (ICs). In one aspect, the present disclosure relates generally to protection from current injection faults in integrated circuits.

### Description of the Related Art

Integrated circuit microcontrollers (MCUs) are increasingly fabricated with leading edge fabrication process technologies (e.g., 16 nanometers) for use with a variety of integrated circuits for different end uses and price target integrated circuits. For example, an automotive MCU may be connected with powertrain engine controllers, body controllers, chassis controllers, safety controllers, or infotainment controllers which range from low cost controllers with minimal feature sets to higher cost, high performance MCUs. All of these factors have an impact on the allowable injection currents that a device can withstand without causing any long-term effect on the device lifetime. In general, an injection current that induces a voltage on the internal structures that is higher than the operating voltage of the device can degrade the lifetime of the transistors and other internal circuitry. As will be appreciated, injection current events can be caused by transient behavior of the circuit arrangement, different power supplies of different parts of this circuit arrangement, any unwanted voltage spikes, etc. Integrated circuit designers seek to account for injection current conditions at the MCU to ensure proper device lifetime, such as by designing the transistor geometry and type, specifying a maximum junction temperature, specifying maximum/minimum voltages/currents for the power supply and I/O pins, and/or including special current injection protection circuitry. However, existing solutions for protecting against current injection faults can impose significant costs in terms of circuit area or operating complexity. For example, existing solutions for protecting against current injection can change the logic state of an I/O pad when responding to a current injection fault. Other existing solutions for protecting against current injection include circuitry that consumes current during normal operation when there is no fault. Other solutions for protecting against current injection only operate during limited power modes, and do not provide protection during the entire lifetime of the product.

As can be seen from the foregoing, the existing solutions for protecting against current injection events are extremely difficult at a practical level by virtue of the difficulty in balancing the cost, complexity, and circuit area requirements with the current injection protection performance of integrated circuits.

### BRIEF DESCRIPTION OF THE DRAWINGS

The present invention may be understood, and its numerous objects, features and advantages obtained, when the following detailed description of a preferred embodiment is considered in conjunction with the following drawings.
Figure 1 depicts a simplified circuit block diagram of a typical general purpose input/output cell for an input/output pad or pin.
Figure 2 depicts a simplified circuit block diagram of an input/output cell connected to positive and negative current injection detectors to provide a current injection protection circuit which clamps the pad voltage at the I/O pad if the pad voltage exceeds the supply voltages in accordance with selected embodiments of the present disclosure.
Figure 3 depicts a simplified circuit schematic diagram of first and second comparators connected to an input/output cell having a stack of cascoded transistor devices with diode-connected transistors that are selected by multiplex selection circuits to drive the output buffer during current injection events to handle current injection faults by clamping the pad voltage at the I/O pad in accordance with selected embodiments of the present disclosure.
Figure 4 depicts a simplified circuit schematic diagram of first and second comparators connected to an input/output cell having a stack of cascoded transistor devices connected as upper and lower inverters that are selected by multiplex selection circuits to drive an output buffer to clamp the pad voltage in accordance with selected second embodiments of the present disclosure.
Figure 5 diagrammatically depicts simulation results for the current injection protection circuit in accordance with selected embodiments of the present disclosure.
Figure 6 comparatively depicts the operation of an I/O cell with and without injection current protection circuitry.

It will be appreciated that for simplicity and clarity of illustration, elements illustrated in the drawings have not necessarily been drawn to scale. For example, the dimensions of some of the elements are exaggerated relative to other elements for purposes of promoting and improving clarity and understanding. Further, where considered appropriate, reference numerals have been repeated among the drawings to represent corresponding or analogous elements.

### DETAILED DESCRIPTION

A method, system, apparatus and associated methods of operation and fabrication are described for protecting an integrated circuit against current injection events at input/output (I/O) pads by providing a current injection protection circuit which is connected to clamp the I/O pad to a first clamped voltage (or a second clamped voltage) in the event of a detected current injection fault when the I/O pad voltage exceeds a first supply voltage (or falls below a second supply voltage). In selected embodiments, the current injection protection circuit may include first and second supply voltage comparators connected over multiplex selection circuits to an output buffer driver to clamp the I/O pad voltage if the I/O pad voltage varies above a first supply voltage (e.g., VDD) or below a second supply voltage (e.g., VSS). In selected embodiments, the first supply voltage comparator may be an overvoltage detector that is connected and configured to compare the I/O pad voltage against the first supply voltage. In addition, the second supply voltage comparator may be an undervoltage detector that is connected and configured to compare the I/O pad voltage against the second supply voltage. If the I/O pad voltage varies above the first supply voltage, the overvoltage detector triggers the output buffer driver (i.e., I/O transmitter) to provide a positive gate (PG) control signal through the multiplex selection circuit to clamp the I/O pad voltage to the first clamped voltage (e.g., VDD + Comparator hysteresis). In similar fashion, if the I/O pad voltage varies below the second supply voltage, the undervoltage detector triggers the output buffer driver (i.e., I/O transmitter) to provide a negative gate (NG) control signal through the multiplex selection circuit to clamp the I/O pad voltage to the second clamped voltage (e.g., VSS - Comparator hysteresis). By forming each of the overvoltage and undervoltage detectors with imbalanced back-to-back current mirrors, the comparators used inside the detectors do not consume current unless there is an injection fault condition at the I/O pad. In addition, the operation of the disclosed current injection protection circuit does not change the logic state of the I/O pad when responding to a current injection event, and can be used to protect against current injection during all power modes to provide protection during the entire lifetime of the product.

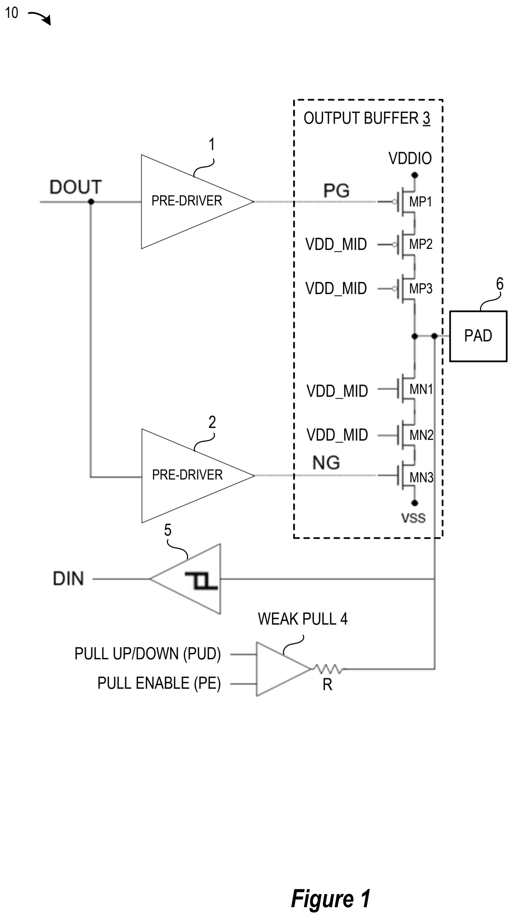

To provide a contextual understanding of the present disclosure, reference is now made to Figure 1 which depicts a simplified circuit block diagram of a general-purpose input/output (GPIO) circuit 10 for an input/output pad or pin 6. As depicted, the GPIO circuit 10 is connected to receive logic control signals (not shown) and output data DOUT from a System-on-Chip (SoC) for transmission over the input/output pad 6 using the pre-driver circuits 1-2, output buffer 3, and weak pull up/down circuit 4. In addition, the GPIO circuit 10 is connected to receive input data from the I/O pad 6 for transmission over the input receiver hysteresis circuit 5 to the SoC as input data DIN. Generally speaking, the GPIO 10, in "normal" operation, translates the low voltage SoC data output signals (e.g., in the range from 0V to 0.8V from SoC) to and from the external signal levels at the input/output pad 6 (e.g., in the range from 0V to 1.8V-5V) in response to control signals provided to the pre-driver circuits 1-2, output buffer 3, weak pull up/down circuit 4, and input receiver hysteresis circuit 5. In the depicted example, the output buffer 3 is split into a lower NFET output stage MN1-3 and an upper PFET output stage MP1-3 which are connected, respectively, to receive the negative gate (NG) and positive gate (PG) control signals from the lower N-side pre-driver 2 and the upper P-side pre-driver 1. Each depicted output stage includes a 3-stage FET connected in series to control the output impedance, leakage, driver strength, and slew rate. Furthermore, the use of a stacked output stage enables a VDDIO supply voltage range that exceeds the safe operating area (SOA) of single FET devices. This is achieved by controlling selected gate terminals of the NFET and PFET output stages by an intermediate bias supply (VDD_MID), which may be at half of the VDDIO voltage level in one embodiment. In particular, the upper PFET output stage includes PFET devices MP1-MP3 connected in series between the supply voltage (e.g., VDDIO) and the PAD. In addition, the lower NFET output stage includes NFET devices MN1-3 connected in series between the PAD and VSS or ground.

To control the operation of the GPIO circuit 10, control signals are provided to specify if data is being transmitted or received, or if the GPIO circuit10 is to be tri-stated, or may enable/disable the weak pull circuit 4, or may specify the slew rate of the output buffer 5, or may enable/disable the input receiver hysteresis circuit 5, etc. In response to a pull enable (PE) and pull up/down (PUD) control signal, the weak pull up/down circuit 4 may be configured to effectively pull the I/O pad 6 toward the high level (VDD) or the low level (VSS) through a series resistor R. In addition, a transmit control signal may be applied to the pre-driver circuits 1, 2 to send or transmit data at a specified speed with a specified drive impedance (e.g., 50Ω), where each pre-driver circuit 1, 2 may include level shifter circuits which shift the low voltage output data DOUT to higher voltage signal levels suitable for the pre-drivers 1, 2. In similar fashion, a receiver control signal may be applied to the input receiver hysteresis circuit 5 which operates independently from the pre-driver circuits 1, 2 to convert higher voltage input data signals from the I/O pad 6 into the lower voltage input data signals DIN.

In the depicted GPIO circuit 10, a current injection event can occur any time the voltage on the I/O pad 6 goes either above VDDIO or below VSS. Certain minimal ranges of injection current may not raise the pad voltage by more than 0.3 V above the power supply voltage. As a result, larger ranges of injection current may cause I/O pad voltages that are more than 0.3 V above power supply voltage. An external voltage limiting device, for example a Schottky diode, may also be used to limit the overvoltage to about 0.3 V above VDDIO, but this comes at additional cost. It should be noted that the injection current occurs when the input voltage to a pin goes above the actual power supply voltage that powers the pin. As described hereinabove, conventional current injection protection solutions add to the cost, size and complexity of IC design and operation, including increased circuit area and operating complexity, altered logic states at the I/O pad, current consumption, and constrained use during limited power modes.

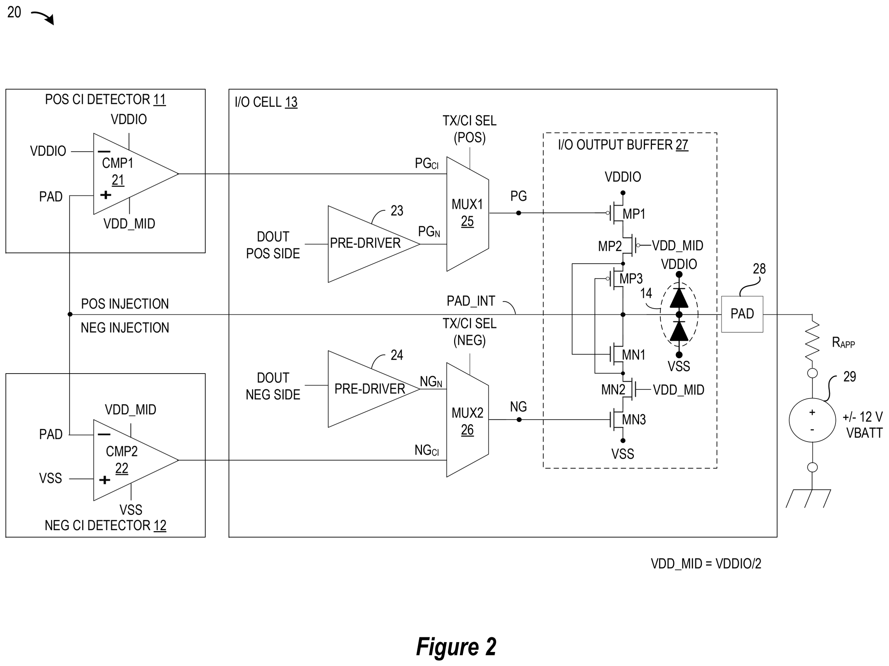

To address these shortcomings and deficiencies of the conventional current injection protection solutions, reference is now made to Figure 2 which depicts a simplified circuit block diagram 20 of an input/output cell 13 connected to positive and negative current injection (CI) detectors 11, 12 to provide a current injection protection circuit which uses the output buffer stage 27 to handle current injection faults by clamping the pad voltage at the I/O pad 28 if the pad voltage falls outside the range between first and second supply voltages (e.g., from VSS to VDDIO). As depicted, the positive CI detector 11 (using a positive overvoltage detector) may be implemented with a first comparator 21 which is supplied by a first supply voltage VDDIO and an intermediate supply voltage VDD_MID that is a relatively low supply voltage compared to the first supply voltage VDDIO. The depicted positive CI detector 11 is also connected to receive the I/O pad voltage (at a non-inverting input) and the first supply voltage VDDIO (at an inverting input) for comparison to output a digital positive current injection gate (PGcr) signal which indicates if a positive current injection event has occurred where the I/O pad voltage is greater than the first supply voltage VDDIO. In similar fashion, the negative CI detector 12 (using an undervoltage detector) may be implemented with a second comparator 22 which is supplied by the intermediate supply voltage VDD_MID and the second supply voltage VSS, where the second supply voltage VSS is a relatively low supply voltage compared to the intermediate supply voltage VDD_MID. In one embodiment, the intermediate supply voltage VDD_MID is biased at the midpoint between VDDIO and VSS. The depicted negative CI detector 12 is also connected to receive the second supply voltage VSS (at a non-inverting input) and the I/O pad voltage (at an inverting input) for comparison to output a digital negative current injection gate (NG_{CI}) signal indicating if the I/O pad voltage is below the second supply voltage VSS.

At the input/output cell 13, positive current injection circuitry is provided to detect and prevent against positive CI events. In particular, a first pre-driver circuit 23 is connected to receive a positive output data DOUT, such as may be generated by a microcontroller, and to generate a "normal" positive gate (PG_{N}) control signal for use in controlling output buffer 27 during "normal" operation when there are no current injection events detected. However, to account for positive current injection events or overvoltage (OV) events detected at the microcontroller, the I/O cell 13 also includes a multiplex selection circuit (MUX1) 25 that is connected to receive the digital positive current injection gate (PG_{CI}) control signal as a first MUX1 input, and to also receive the "normal" positive gate (PG_{N}) control signal at a second MUX1 input. In response to a transmit/current injection selection signal for positive CI detection events TX/CI SEL(POS), the multiplex selection circuit (MUX1) 25 selects one of the first and second MUX1 inputs for output as the positive gate (PG) control signal to the output buffer 27.

In similar fashion, the input/output cell 13 includes negative current injection circuitry to detect and prevent against negative CI events. In particular, a second pre-driver circuit 24 is connected to receive a negative output data DOUT, such as may be generated by a microcontroller, and to generate a "normal" negative gate (NG_{N}) control signal for use in controlling output buffer 27 during "normal" operation when there are no current injection events detected. And to account for negative current injection events or undervoltage (UV) events detected at the microcontroller, the I/O cell 13 also includes a multiplex selection circuit (MUX2) 26 that is connected to receive the digital negative current injection gate (NG_{CI}) control signal as a first MUX2 input, and to also receive the "normal" negative gate (NG_{N}) control signal at a second MUX2 input. In response to a transmit/current injection selection signal for negative CI detection events TX/CI SEL(NEG), the multiplex selection circuit (MUX2) 26 selects one of the first and second MUX2 inputs for output as the negative gate (NG) control signal to the output buffer 27. As disclosed herein, the MUX selection signals TX/CI SEL(POS), TX/CI SEL(NEG) are identical except that TX/CI SEL(POS) signal is referenced to the VDDIO and an internal reference supply (e.g., VDD _MID), while the TX/CI SEL(NEG) signal is referenced to the internal reference supply (e.g., VDD_MID) and VSS.

In the depicted output buffer 27, a pair of complementary diodes 14 are connected to provide an electrostatic discharge (ESD) protection device connected in series between the first supply voltage VDDIO and the second supply voltage VSS, with the mid-node of the diode stage connected to the PAD 28, to protect the PFET and NFET devices MP1-3, MN1-3 of the output buffer 27 against damage from ESD events. The output buffer 27 includes an upper PFET output stage MP1-3 and lower NFET output stage MN1-3 that are connected, respectively, to receive the positive gate (PG) control signal and negative gate (NG) control signal from the multiplex selection circuits 25, 26. In particular, the upper PFET output stage includes PFET devices MP1-MP3 which are source-drain connected in series as a cascode stack between the first supply voltage VDDIO and the I/O pad 28. In the PFET device stack, the high side PFET device MP1 has its gate connected to the PG control signal, the middle PFET device MP2 has its gate connected to the intermediate supply voltage VDD_MID, and the bottom PFET device MP3 has its gate connected to the lower NFET output stage MN1-3 at the shared source/drain node between the NFET devices MN1, MN2, as shown. In addition, the lower NFET output stage includes NFET devices MN1-3 which are source-drain connected in series as a cascode stack between the I/O pad 28 and the second supply voltage VSS. In the NFET device stack, the bottom side NFET device MN3 has its gate connected to the NG control signal, the middle NFET device MN2 has its gate connected to the intermediate supply voltage VDD_MID, and the high side NFET device MN1 has its gate connected to the upper NFET output stage MP1-3 at the shared source/drain node between the PFET devices MP2, MP3, as shown. In other embodiments, a reference voltage (VREF) may separately be connected to the gate terminals of the interior PFET and NFET device MP2-MP3, MN1-MN2. In this configuration, the PFET device stack MP1-MP3 is used to clamp the voltage at the I/O pad 28 in response to positive injection faults, and the NFET device stack MN1-MN3 is used to clamp the voltage at the I/O pad 28 in response to negative injection faults.

The simplified circuit block diagram 20 of Figure 2 contains an external voltage source 29 coupled to the I/O pad 28 via a resistor R_{APP}. This is used to demonstrate a means of injecting current to the I/O pad. For example, if the voltage source 29 is biased at +12V, positive current gets injected. If the voltage source 29 is biased at -12V, negative current gets injected. The injection current is limited by the series resistor R_{APP}. During normal operation when the I/O cell 13 is configured in transmit (TX) mode (data output mode), the pre-drivers 23, 24 control the gate controls of the I/O output buffer 27 because the transmit/current injection selection signals cause the multiplex selection circuits 25, 26 to output the "normal" PG_{N} and NG_{N} control signals from the pre-drivers 23, 24 to the output buffer 27. However, when the transmit/current injection selection signals indicate that the I/O cell 13 is not configured in transmit (TX) mode, e.g. if operated in receive (RX) mode (data input mode) or in a tri-state (high-impedance) pad mode, then the multiplex selection circuits 25, 26 output the positive and negative current injection gate (PG_{CI}, NG_{CI}) signals from the pre-driver comparators 21, 22 to control the output buffer 27. During a CI event, the application resistor Rapp and the resulting Rds-on of the stacked transistors in the output buffer 27 form a resistive divider. For an overvoltage (OV) fault where the injection current I_{injection} is positive, the high side PFET device MP1 in the output buffer 27 will be turned ON to effectively clamp the voltage on the I/O pad 28 to VDDIO + Comparator hysteresis (trip-point). And for an undervoltage (UV) fault where the injection current I_{injection} is negative, the low side NFET device MN3 in the output buffer 27 will be turned ON to effectively clamp the voltage on the I/O pad 28 to VSS - comparator hysteresis (trip-point).

In cases where the I/O cell 133 is configured in TX mode and a CI event occurs, the pad 28 drives to either VDDIO or VSS and the injection current would be absorbed by the already "ON " driver without a safe operating area (SOA) violation.

As depicted in Figure 2, the I/O pad 28 is connected in feedback directly to inputs of the positive and negative current injection (CI) detectors 11, 12. As will be appreciated by those skilled in the art, these direct connections can result in safe operating area (SOA) violations on the transistors at the inputs of comparators CMP1 and CMP2 because the voltage at pad 28 ranges from VSS to VDDIO and the comparators CMP1 (which uses VDDIO and VDD_MID as its supply rails) and CMP2 (which uses VDD_MID and VSS as its supply rails) may not be suitable for such a large input voltage range.

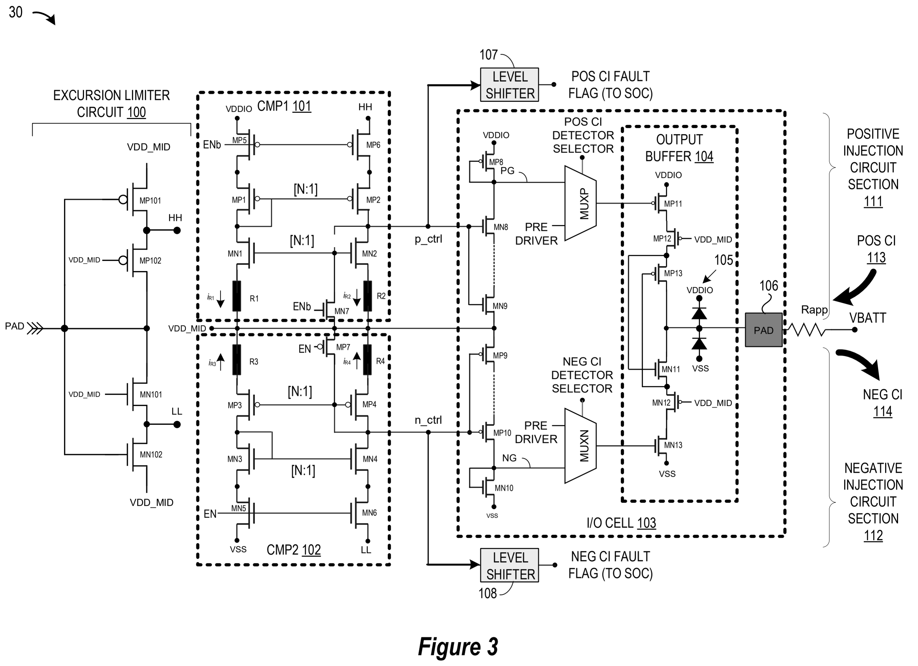

To provide additional details for an improved understanding of selected embodiments of the present disclosure, reference is now made to Figure 3 which depicts a simplified circuit schematic diagram of a GPIO circuit 30 having first and second comparators 101, 102 connected to an input/output cell 103 to provide current injection protection circuitry which is connected to clamp the I/O pad 106 to a first clamped voltage (or a second clamped voltage) in the event of a detected current injection fault. Such faults can occur when the I/O pad 106 experiences a positive current injection event 113 when the I/O pad voltage exceeds a first supply voltage (VDDIO) or when the I/O pad 106 experiences a negative current injection event 114 when the I/O pad voltage falls below a ground supply voltage (VSS).

As depicted, the I/O cell 103 is divided into a positive injection circuit section 111 and a negative injection circuit section 112, and includes a pair of complementary diodes 105 connected in series between the supply voltages VDDIO, VSS to provide a ESD protection for the pad 106 and the output buffer 104 connected to the pad. In addition, the I/O cell 103 includes a stack of cascoded transistor devices MP8-MP10, MN8-MN10 with diode-connected transistors MP8, NM10 which are connected and configured to generate a positive gate (PG) control signal and a negative gate (NG) control signal that are provided as first inputs to multiplex selection circuits MUXP, MUXN. Each multiplex selection circuit MUXP, MUXN also has a second input for receiving a pre-driver input gate control signal for use with TX mode operations, as shown. In the positive injection circuit section 111, the multiplex selection circuit MUXP responds to a POS CI detector selector signal to selectively output one of the control signal inputs. In addition, the multiplex selection circuit MUXN in the negative injection circuit section 112 responds to a NEG CI detector selector signal to selectively output one of the control signal inputs. In this way, the multiplex selection circuits MUXP, MUXN selectively output the positive and negative gate control signals PG, NG to drive the output buffer 104 during current injection events to handle current injection faults by clamping the pad voltage at the I/O pad 106.

Rather than directly comparing the I/O pad voltage to the supply voltages VDDIO, VSS, an excursion limiter circuit 100 is provided to effectively separate the I/O pad voltage PAD into a first HH signal and a second LL signal so that the voltages delivered to the comparators 101, 102 do not exceed SOA limitations inside the comparators. As a result, the first HH signal is referenced to logic "low" being VDD_MID, and the second LL signal is referenced to logic "high" being VDD_MID. Consider the example of the VDDIO supply being at 3.6V and the VDD_MID node at 1.8V. When the I/O pad voltage signal is between 0 to 1.8V, the LL signal will track the I/O pad voltage from 0V to 1.8V and the HH signal will remain at 1.8V. When the I/O pad voltage signal is between 1.8 to 3.6 volts, the HH signal will track the I/O pad voltage from 1.8V to 3.6V and the LL signal will remain at 1.8V. In effect, the excursion limiter circuit 100 splits the I/O pad voltage signal as a way to protect the inside devices of the comparators.

In the depicted example, the excursion limiter circuit 100 is split into a lower NFET stage MN101-102 and an upper PFET stage MP101-102 which are connected to receive the I/O pad voltage (PAD) as an input, and to generate the voltage-limited outputs HH, LL. Each depicted stage includes a 2-stage FET connected in series to generate a voltage-limited output. In particular, the upper PFET stage includes PFET devices MP101-MP102 connected in series between the intermediate supply voltage VDD_MID = VDDIO/2 and the I/O pad voltage to generate the voltage-limited output HH at the shared source/drain node between the PFET devices MP101, MP102. In addition, the lower NFET stage includes NFET devices MN101-102 connected in series between the I/O pad voltage and intermediate supply voltage VDD_MID = VDDIO/2 to generate the voltage-limited output LL at the shared source/drain node between the NFET devices MN101, MN102. In this configuration, when the I/O pad voltage is at or above VDD_MID as during a positive CI event, the excursion limiter circuit 100 responds by generating the voltage-limited output HH as a clamped version of the I/O PAD voltage signal, tracking the I/O pad within a range at or above VDD_MID. In addition, when the I/O pad voltage is at or below VDD_MID as during a negative CI event, the excursion limiter circuit 100 responds by generating the voltage-limited output LL as a clamped version of the I/O PAD voltage signal, tracking the I/O pad within a range at or below VDD_MID. If the PAD voltage were applied straight to the HH, LL input nodes of the comparators 101, 102, it could cause SOA violations.

As depicted, the first comparator CMP1 101 is implemented with unbalanced back-to-back current mirrors MP1-MP2, MN1-MN2 which are connected to compare the first I/O supply voltage VDDIO to the high side voltage HH generated by the excursion limiter circuit 100 during a positive current injection event, thereby generating a positive current injection control signal (p_ctrl) which indicates that a positive current injection event has occurred. In similar fashion, the second comparator CMP2 102 is implemented with unbalanced back-to-back current mirrors MP3-MP4, MN5-MN6 which are connected to compare the second I/O supply voltage VSS to the low side voltage LL generated by the excursion limiter circuit 100 during a negative current injection event, thereby generating a negative current injection control signal (n_ctrl) which indicates that a negative current injection event has occurred.

By providing comparator enable signal ENb, EN to the first and second comparators 101, 102, the current injection protection circuitry is operational only when the output buffer 104 (transmitter) is disabled. Conversely, when the output buffer 104 (transmitter) is ON, the comparator enable signal ENb, EN are used to disable the first and second comparators 101, 102, and the multiplex selection circuits MUXP, MUXN are used to route the pre-driver gate control signals to the output buffer 104. In one embodiment, the logic levels of EN and ENb are opposite. In another embodiment, the logic levels of EN and ENb are matched with the POS/NEG CI detector selector signals of the multiplex selection circuits MUXN and MUXP in a way that the EN is at logic "high" (and ENb at logic "low") if the MUXN and MUXP are configured for a CI event detection.

As depicted, the positive current injection control signal (p_ctrl) and negative current injection control signal (n_ctrl) are transmitted to the level shifter blocks 107, 108 which respectively generate a positive CI fault flag or negative CI fault flag to the System-on-Chip (SoC). In particular, the level shifter 107 translates the p_ctrl signal, for example, from the I/O voltage domain (e.g., VDD_IO = 3.6V) to the core voltage domain (e.g., approximately 1 volt). Similarly, the level shifter 108 translates the n_ctrl signal from the I/O voltage to the core voltage domain. In addition, the positive current injection control signal (p_ctrl) is provided to the stack of cascoded transistor devices as a gate control signal for the NFET devices MN8, MN9, and the negative current injection control signal (n_ctrl) is provided to the stack of cascoded transistor devices as a gate control signal for the PFET devices MP9, MP10.

In operation when there is no overvoltage (OV) fault, the two unbalanced back-to-back current mirrors (MP1-MP2 and MN1-MN2) force the first comparator CMP1 101 into an OFF state with minimal power consumption (off state leakage). The MP1-MP2 (and MN1-MN2) drive strength ratio (where "drive strength" of a device is measured by its W/L) defines the voltage difference between HH and VDDIO necessary to trigger the detector. When there is an OV fault caused by a positive CI event 113 and the high side voltage HH exceeds the supply voltage VDDIO by a trip threshold amount, the first comparator CMP1 101 generates the positive current injection control signal (p_ctrl) which causes the stack of cascoded transistor devices MP8, MN8, MN9 to generate the positive gate control signal PG. In effect, the stacked devices MP8, MN8, MN9 essentially form simple inverter stages, with the devices MN8, MN9 forming a pull-down device controlled by the inverter input and the MP8 device forming a pull-up (ballast) device. And while the devices MN9, MN8 (as well as the devices MP9, MP10) are stacked, a single longer channel device could be used instead. When selected by the multiplex selection circuit MUXP, the control signal PG turns ON the upper PFET output stage MP11-13 of the output buffer 104. As the source-to-gate voltage Vsg of the MP2 device increases (MP2_Vsg > MP1_Vsg), the two unbalanced back-to-back current mirrors (MP1-MP2 and MN1-MN2) turn ON, causing current flowing in the comparator branches from VDDIO to VDD_MID and from HH to VDD_MID. As a result, the control node p_ctrl is asserted HIGH, turning on the MN8 and MN9 devices to pull current from VDDIO through the diode-connected MP8 device which functions as a diode-connected current mirror input. When selected for output by the multiplex selection circuit MUXP, the current from the MN8, MN9 devices is mirrored via the diode-connected MP8 device to the PMOS device MP11 of the output buffer 104. The PMOS buffer devices turn ON, thereby clamping the voltage at the I/O pad 106 to VDDIO. At the I/O pad 106, application resistor Rapp is connected which forms a resistive divider with the on-resistance (Rds-on) of the PMOS's output buffer devices MP11-MP13. As long as the voltage at the I/O pad is kept slightly above VDDIO to exceed the comparator/detector trip-point, the output buffer 104 clamps the I/O pad voltage to VDDIO, thereby protecting the I/O pad from positive voltage excursions during current injection events 113.

In similar fashion, when there is an undervoltage (UV) fault caused by a negative CI event 114 and the low side voltage LL falls below the supply voltage VSS by a trip threshold amount, the second comparator CMP2 102 generates the negative current injection control signal (n_ctrl) which causes the stack of cascoded transistor devices MP9, MP10, MN10 to generate the negative gate control signal NG. When selected by the multiplex selection circuit MUXN, the control signal NG turns ON the lower NFET output stage MN11-13 of the output buffer 104. As the gate-to-source voltage Vgs of the MN4 device increases (MN4_Vgs > MN3_Vgs), the two unbalanced back-to-back current mirrors (MN3-MN4 and MP3-MP4) turn ON, causing current flowing in the comparator branches from VDD_MID to VSS and from VDD_MID to LL. As a result, the control node n_ctrl is asserted LOW, turning on the MP9, MP10 devices to pull current from VSS through the diode-connected MN10 device which functions as a diode-connected current mirror input. When selected for output by the multiplex selection circuit MUXN, the current from the MP9, MP10 devices is mirrored via the diode-connected MN10 device to the NMOS device MN13 of the output buffer 104. The NMOS buffer devices turn ON, thereby clamping the voltage at the I/O pad 106 to VSS.

The diode-connected MP8 device imposes a lower limit to the PG voltage of about one threshold voltage (Vt) below the first supply voltage VDDIO. Therefore, the current sourced by the upper PFET output stage MP11-13 to absorb the positive injection current 113 has a limit that is proportional to the drive strength of MN8, MN9. In this embodiment, the first comparator CMP1 101 and inverter stage MN8, MN9, MP8 behave more like an analog amplifier during the CI event, meaning that they do not completely turn ON the output buffer 104. Instead they provide just the necessary drive current through the output buffer to keep the voltage at the I/O pad 106 slightly above VDDIO, roughly matching the trip point of the comparator CMP1. Likewise, the NG node voltage controls the lower NFET output stage MN11-13 during a negative current injection event 114 when the voltage at the I/O pad 106 goes below VSS.

Depending on the battery voltage source (VBATT) used to generate the positive or negative current injection events 113, 114, the application resistor Rapp may not be needed, though there will always be some source impedance associated with the battery voltage source.

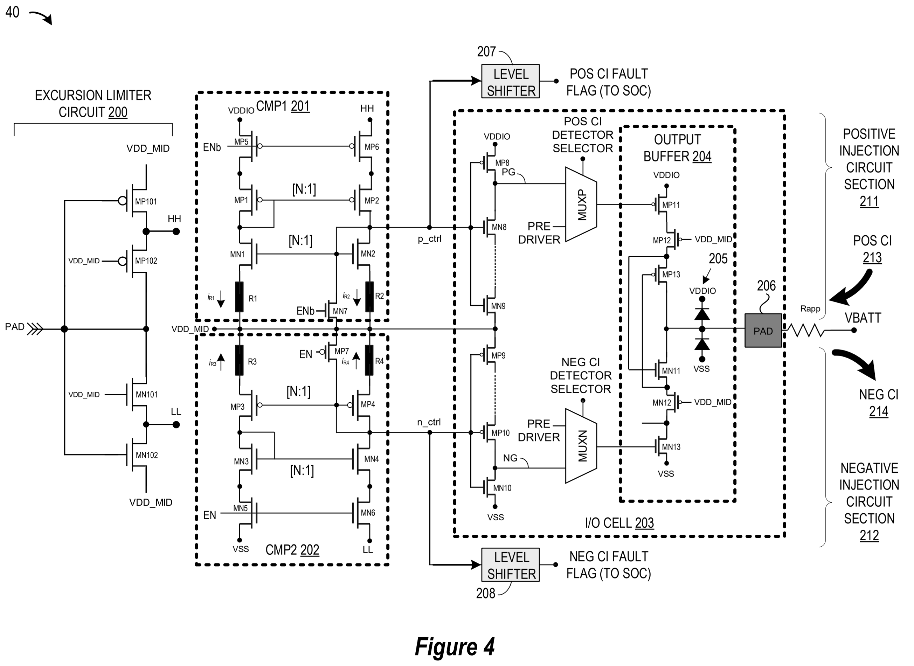

To provide additional details for an improved understanding of selected embodiments of the present disclosure, reference is now made to Figure 4 which depicts a simplified circuit schematic diagram of a GPIO circuit 40 which is very similar to the GPIO circuit 30 shown in Figure 3, except that the stack of cascoded transistor devices MP8-10, MN8-10 in the output buffer 204 does not include diode-connected transistors. In particular, the GPIO circuit 40 includes first and second comparators 201, 202 connected to an input/output cell 203 having a stack of cascoded transistor devices connected as an upper inverter MP8/MN8/MN9 and a lower inverter MP9/MP10/MN10 that are selected by multiplex selection circuits MUXP, MUXN to drive an output buffer 204 to clamp the I/O pad 206 to a first clamped voltage (or a second clamped voltage) in the event of a detected current injection fault that occurs when the I/O pad 206 experiences a positive current injection event 213 or a negative current injection event 214.

Similar to the I/O cell 103 shown in Figure 3, the I/O cell 203 includes a positive injection circuit section 211 and a negative injection circuit section 212, with the ESD protection diodes 205 connected in series between the supply voltages VDDIO, VSS to provide ESD protection for the pad 206 and the output buffer 204 connected to the pad 206. The I/O cell 203 also includes a stack of cascoded transistor devices, including an upper stage MP8, MN8, MN9 and a lower stage MN10, MP10, MP9. The upper stage MP8, MN8, MN9 devices are connected in series between the first supply voltage VDDIO and intermediate supply voltage VDD_MID to form a first inverter with their gate terminals all connected in common to receive the positive current injection control signal (p_ctrl) and to generate a positive gate (PG) control signal, as shown. In addition, the lower stage MN10, MP10, MP9 devices are connected in series between the intermediate supply voltage VDD_MID and the second supply voltage VSS to form a second inverter with their gate terminals all connected in common to receive the negative current injection control signal (n_ctrl) and to generate a negative gate (NG) control signal, as shown. The control signals PG, NG are provided as first inputs to multiplex selection circuits MUXP, MUXN, each of which also has a second input for receiving a pre-driver input gate control signal for use with TX mode operations. In this way, the multiplex selection circuit MUXP in the positive injection circuit section 211 responds to a POS CI detector selector signal to selectively output one of the control signal inputs, and the multiplex selection circuit MUXN in the negative injection circuit section 112 responds to a NEG CI detector selector signal to selectively output one of the control signal inputs. In this way, the multiplex selection circuits MUXP, MUXN selectively output the positive and negative gate control signals PG, NG to drive the output buffer 204 during current injection events to handle current injection faults by clamping the pad voltage at the I/O pad 206.

As disclosed herein, the I/O pad voltage may be connected directly to the first and second comparators 201, 202 for comparison to the supply voltages VDDIO, VSS. However, in selected embodiments, an excursion limiter circuit 200 is provided to separate the I/O pad voltage PAD into a first HH signal and a second LL signal so that the voltages delivered to the comparators 201 and 202 do not exceed SOA limitations inside the comparators. In the depicted excursion limiter circuit 200, a lower NFET stage MN101-102 and an upper PFET stage MP101-102 are connected to receive the I/O pad voltage (PAD) as an input, and to generate the voltage-limited outputs HH, LL. In particular, the upper PFET stage includes PFET devices MP101-MP102 connected in series between the intermediate supply voltage VDD_MID = VDDIO/2 and the I/O pad voltage to generate the voltage-limited output HH at the shared source/drain node between the PFET devices MP101, MP102. In addition, the lower NFET stage includes NFET devices MN101-102 connected in series between the I/O pad voltage and intermediate supply voltage VDD_MID to generate the voltage-limited output LL at the shared source/drain node between the NFET devices MN101, MN102. As a result, when the I/O pad voltage is at or above VDD_MID as during a positive CI event 213, the excursion limiter circuit 200 responds by generating the voltage-limited output HH as a clamped version of the I/O PAD voltage signal, tracking the I/O pad within a range at or above VDD_MID. In addition, when the I/O pad voltage is at or below VDD_MID as during a negative CI event 214, the excursion limiter circuit 200 responds by generating the voltage-limited output LL as a clamped version of the I/O PAD voltage signal, tracking the I/O pad within a range at or below VDD_MID.

The depicted first and second comparators 201, 202 are designed and operate in exactly the same way as the comparators 101, 102 shown in Figure 3, and are therefore not described in further detail. Similarly, the generated positive and negative current injection control signals p_ctrl, n_ctrl are provided to the level shifters 207, 208 to perform the same fault signaling function to the SoC as described in Figure 3. As a result, the positive current injection control signal (p_ctrl) and negative current injection control signal (n_ctrl) generated by the first and second comparators 201, 202 are provided to the stack of cascoded transistor devices as, respectively, the gate control signal for the first inverter (formed with upper stage MP8, MN9, MN9 devices) and the second inverter (formed with lower stage MN10, MP10, MP9 devices). In turn, the first and second inverters generate the positive gate control signal PG (when there is an OV fault caused by a positive CI event 213) or the negative gate control signal NG (when there is an undervoltage (UV) fault caused by a negative CI event 214).

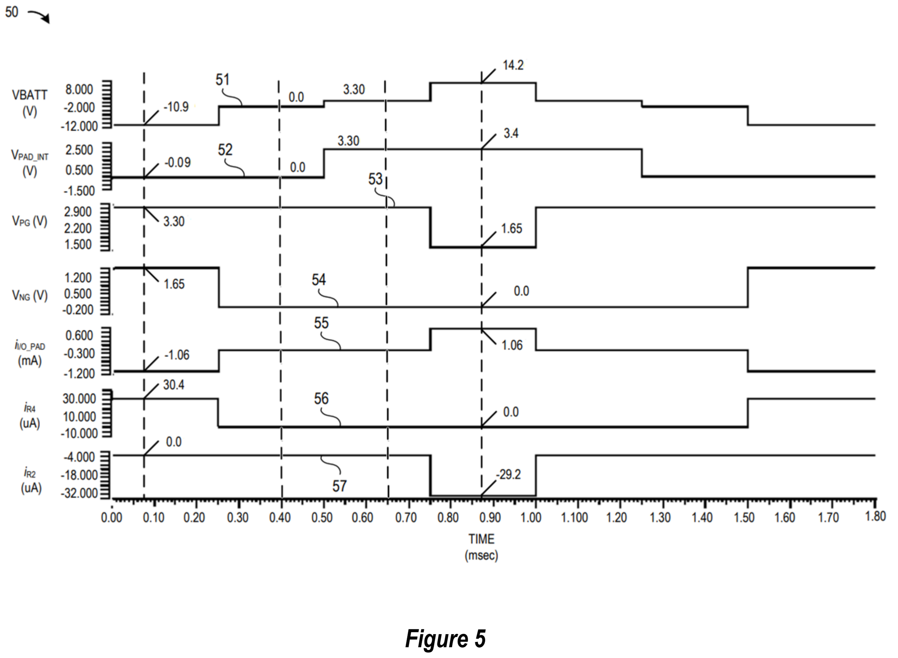

To provide additional details for a contextual understanding of the present disclosure, reference is now made to Figure 5 which provides a diagrammatically depiction 50 of voltage and current simulations 51-57 for the current injection protection circuit which protects against current injection events at an input/output (I/O) pad. As shown with the VBATT (battery voltage) timing waveform 51, the voltage applied to the I/O pad varies over time, starting at -10.9V (a negative injection fault or undervoltage event) and stepping up to 14.2V (a positive injection fault or overvoltage event) before stepping back down to -10.9V. As indicated by the positive gate (V_{PG}) control signal waveform 53, the positive injection fault is signaled when the V_{PG} control signal has a "low" logic value (e.g., 1.65V), but not when it has a "high" logic value (e.g., 3.3V). Similarly, the negative gate (V_{NG}) control signal waveform 54 signals the negative injection fault when the V_{NG} control signal has a "high" logic value (e.g., 1.65V), but not when it has a "low" logic value (e.g., 0V).

During a positive injection fault, the timing waveform 55 for the I/O pad current (1_{I/O_PAD}) shows that the current increases to 1.06mA during the positive current injection event which occurs at the time interval from 750us to 1ms. However, due to the current injection protection circuit, the timing waveform 52 for the I/O pad voltage (V_{PAD_INT}) shows that the I/O pad voltage remains at 3.4V which is 0.1V above VDDIO=3.3V, despite the battery voltage VBATT having 14.2V connected to the I/O pad through the application resistor Rapp. This is accomplished by the unbalanced back-to-back current mirrors in the comparators which source the i_{R1} and i_{R2} shown in Figure 3 during the positive injection fault, as shown with the timing waveform 57. As a result, the *i*_{I/O_PAD} timing waveform 55 shows that the current injection protection circuit limits the I/O pad voltage from a positive current injection fault. As disclosed herein, the maximum current injection is defined by the output driver Rdson and the resistance value of the application resistor Rapp (which may be in the range of 3kΩ).

During negative injection fault, the timing waveform 55 for the I/O pad current (*i*_{I/O_PAD}) shows that the current decreases to -1.06 mA during the negative current injection event which occurs at the time interval from 0us to 250us. However, due to the current injection protection circuit, the timing waveform 52 for the I/O pad voltage (V_{PAD_INT}) shows that the I/O pad voltage remains at -0.09V which is 0.09V below VSS=0V, despite the battery voltage VBATT having -10.9V connected to the I/O pad through the application resistor Rapp. This is accomplished by the unbalanced back-to-back current mirrors in the comparators which source the *i_{R3}* and *i*_{R4} shown in Figure 3 during the negative injection fault, as shown with the timing waveform 56. As a result, the *i*_{I/O_PAD} timing waveform 55 shows that the current injection protection circuit limits the I/O pad voltage from a negative current injection fault.

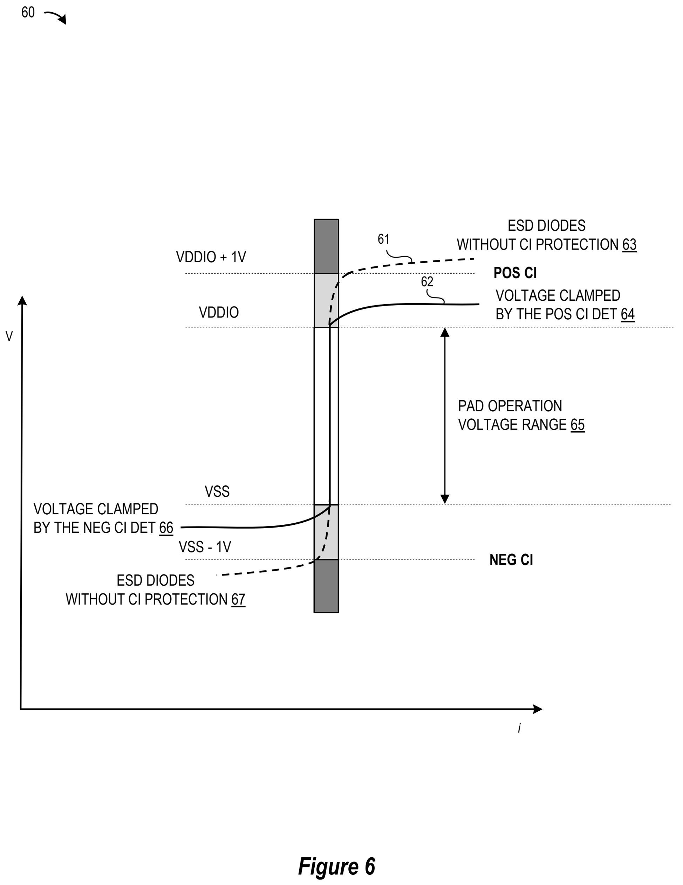

To provide additional details for an improved understanding of selected embodiments of the present disclosure, reference is now made to Figure 6 which comparatively depicts the operation of an I/O cell with and without injection current protection circuitry. The first voltage-current waveform 61 is illustrated with a dashed line to depict the performance of a conventional I/O cell which includes only ESD diode protection devices connected at the I/O pad. As illustrated with the first voltage-current waveform 61, the conventional I/O cell will respond to negative current injection faults with injection current values that go below the VSS supply voltage area 66 and into the negative current injection area 67 since they have only ESD diode protection. In addition, the first voltage-current waveform 61 shows that the conventional I/O cell will respond to positive current injection faults with injection current values that go above the VDDIO supply voltage and into the positive current injection area 63 since they have only ESD diode protection.

In contrast, the second voltage-current waveform 62 is illustrated with a solid line to depict the performance of an I/O cell which includes the injection current protection circuitry disclosed herein. As illustrated with the second voltage-current waveform 62, the I/O cell with injection current protection circuitry will respond to negative current injection faults by clamping the injection current values to stay within the clamped voltage area 66 (e.g., above VSS - 1V) without proceeding into the negative current injection area 67. In addition, the second voltage-current waveform 62 shows that the I/O cell with injection current protection circuitry will respond to positive current injection faults with injection current values that stay within the clamped voltage area 64 (e.g., below VDDIO + 1V) without proceeding into the positive current injection area 63.

An integrated circuit is provided with a signal node/IO pad in an output buffer that is protected by a current injection protection circuit which includes first and second comparators connected between a first voltage supply and a second voltage supply to generate first and second control signals in response to, respectively, a positive or negative injected current at the signal node, and which also includes a pre-driver stack of transistors which generate, respectively, a positive gate control signal and negative gate control signal, and which also includes a multiplex selection circuit connected to output the positive gate control signal and negative gate control signal to the output buffer to clamp signal node to a first clamped voltage if a voltage on the signal node exceeds the first supply voltage or to a second clamped voltage if a voltage on the signal node falls below the second supply voltage.

By now it should be appreciated that there has been provided an integrated circuit having a current injection protection circuit and associated methods of operation and fabrication for protecting the integrated circuit. As disclosed, the integrated circuit includes an external signal node connected to receive an injection current. In addition, the integrated circuit includes an output buffer having a fist output stage connected between a first voltage supply and the external signal node. The integrated circuit also includes a current injection protection circuit connected between the first voltage supply and a second voltage supply. The disclosed current injection protection circuit includes a first comparator configured to generate a first current injection control signal by comparing the first voltage supply to a first overvoltage signal generated from a voltage on the external signal node. In selected embodiments, the first comparator includes an unbalanced back-to-back current mirror connected between the first voltage supply and an intermediate reference voltage between the first and second voltage supplies. In addition, the disclosed current injection protection circuit includes a multiplex selection circuit which includes a first input connected to receive a first gate control signal that is generated from the first current injection control signal, a second input connected to receive a first pre-driver signal, and an output connected to a control gate terminal of the output buffer which clamps the external signal node to the first supply voltage if the voltage on the external signal node passes a trip threshold of the first comparator. In selected embodiments, the current injection protection circuit also includes a pre-driver stack of transistors connected in a cascode configuration between the first voltage supply and a second voltage supply to receive the first current injection control signal and to generate the first gate control signal in response to the first current injection control signal. In selected embodiments, the pre-driver stack of transistors includes a diode-connected PFET device connected in series with one or more NFET devices between the first voltage supply and the intermediate reference voltage to generate the first gate control signal in response to a positive injected current at the external signal node. In other selected embodiments, the pre-driver stack of transistors includes a diode-connected NFET device connected in series with one or more PFET devices between the intermediate reference voltage and the second supply voltage to generate the first gate control signal in response to a negative injected current at the external signal node. In other selected embodiments, the pre-driver stack of transistors includes a first inverter connected between the first voltage supply and the intermediate reference voltage to generate the first gate control signal in response to a positive injected current at the external signal node. In other selected embodiments, the pre-driver stack of transistors includes a second inverter connected between the intermediate reference voltage and the second supply voltage to generate the first gate control signal in response to a negative injected current at the external signal node. In selected embodiments, the disclosed current injection protection circuit may also include an excursion limiter circuit connected to the external signal node to generate the first overvoltage signal.

In another form, there is provided a method, apparatus, and circuit for controlling I/O pad voltage excursions past a reference voltage that are caused by current injection fault. As disclosed, the method includes selectively supplying a first pair of predriver gate control signals to an output buffer during normal operation, where the output buffer is connected to drive an I/O pad between a first reference voltage and a second reference voltage during normal operation. In selected embodiments, the one or more multiplexer selection circuits are connected and configured to selectively supply the first pair of predriver gate control signals to the output buffer during normal operation. In such embodiments, the one or more multiplexer selection circuits may be connected and configured to selectively supply the second pair of predriver gate control signals to the output buffer in response to the detected current injection event. The disclosed method also includes detecting a current injection event which causes an I/O pad voltage excursion past either the first or second reference voltages. In selected embodiments, a positive current injection comparator circuit is connected and configured to detect a positive current injection event which causes a positive I/O pad voltage excursion past a VDD reference voltage. In such embodiments, the output buffer may include a first PFET device connected in series with one or more additional PFET devices between the first reference voltage and the I/O pad, where the first PFET device is turned ON in response to the second pair of gate control signals to clamp the I/O pad voltage to the first clamped voltage when there is a positive I/O pad voltage excursion past the VDD reference voltage. In other selected embodiments, a negative current injection comparator circuit is connected and configured to detect a negative current injection event which causes a negative I/O pad voltage excursion past a VSS reference voltage. In such embodiments, the output buffer may include a first NFET device connected in series with one or more NFET devices between the second reference voltage and the I/O pad, where the first NFET device is turned ON in response to the second pair of gate control signals to clamp the I/O pad voltage to the second clamped voltage when there is a negative I/O pad voltage excursion past the VSS reference voltage. In addition, the disclosed method includes selectively supplying a second pair of predriver gate control signals to the output buffer in response to the detected current injection event, where the output buffer is connected to clamp the I/O pad voltage to a first clamped voltage within approximately one volt of whichever of the first reference voltage or second reference voltage which experienced the I/O pad voltage excursion during the detected current injection event.

In yet another form, there is provided an electronic device, method, and system for preventing or controlling I/O pad voltage excursions that are caused by current injection fault. As disclosed, the electronic device includes an application circuit, a first supply rail having a first reference voltage, a second supply rail having a second reference voltage different from the first reference voltage, and an I/O pad connected to said application circuit. In addition, the electronic circuit includes a protection circuit for protecting said application circuit from an injected current at the I./O pad. As disclosed, the protection circuit includes an output driver that is connected and configured to drive the I/O pad towards a first reference voltage during normal operation. In addition, the protection circuit includes one or more first pre-driver circuits that are connected and configured to generate first pre-driver gate control signals during normal operation. The protection circuit also includes one or more current injection detector circuits that are connected and configured to generate second pre-driver gate control signals in response to detecting a current injection event at the I/O pad. In addition, the protection circuit includes one or more multiplexer selection circuits connected and configured to supply the first pre-driver gate control signals to the output driver during normal operation, and to supply the second pre-driver gate control signals to the output driver during normal operation. In this configuration, the output driver is connected to clamp the I/O pad voltage to a first clamped voltage within approximately one volt of the first reference voltage during the detected current injection event. In selected embodiments, the first reference voltage is a VDD reference voltage, and the one or more current injection detector circuits include a positive current injection comparator circuit that is connected and configured to detect a positive current injection event which causes the I/O pad voltage to exceed the VDD reference voltage. In other selected embodiments, the first reference voltage is a VSS reference voltage, and the one or more current injection detector circuits include a negative current injection comparator circuit that is connected and configured to detect a negative current injection event which causes the I/O pad voltage to fall below the VSS reference voltage. In selected embodiments, the protection circuit may also include a first stack of cascoded transistor devices with a first diode-connected PFET device connected in series with one or more additional NFET devices between the first reference voltage and the I/O pad, where the first stack of cascoded transistor device is connected and configured to generate, in response to the second pre-driver gate control signals, a positive gate (PG) control signal that is provided as a first input to the one or more multiplexer selection circuits. In other selected embodiments, the protection circuit may also include a first stack of cascoded transistor devices with a first PFET device connected in series with one or more additional NFET devices between the first reference voltage and the I/O pad, where the first stack of cascoded transistor device is connected and configured to generate, in response to the second pre-driver gate control signals, a positive gate (PG) control signal that is provided as a first input to the one or more multiplexer selection circuits.

Although the described exemplary embodiments disclosed herein are directed to a current injection protection circuit design and methodology which includes first and second supply voltage comparators connected over multiplex selection circuits to an output buffer driver to clamp the I/O pad voltage if the I/O pad voltage varies above a first supply voltage (e.g., VDD) or below a second supply voltage (e.g., VSS), the present disclosure is not necessarily limited to the example embodiments which illustrate inventive aspects of the present invention that are applicable to a wide variety of circuit designs and operations. For example, the disclosed current injection protection circuit design and methodology can provide injection fault protection benefits for CMOS gates of a functional receiving circuit or block. Thus, the particular embodiments disclosed above are illustrative only and should not be taken as limitations upon the present invention, as the invention may be modified and practiced in different but equivalent manners apparent to those skilled in the art having the benefit of the teachings herein. Accordingly, the identification of the circuit design and embodiments provided herein is merely by way of illustration and not limitation, and other circuit arrangements may be used in order to provide current injection protection within the spirit and scope of the invention as defined by the appended claims so that those skilled in the art should understand that they can make various changes, substitutions and alterations without departing from the spirit and scope of the invention in its broadest form.

The preceding merely illustrates the principles of certain examples. It will thus be appreciated that those skilled in the art will be able to devise various arrangements which, although not explicitly described or shown herein, embody the principles and are included within their spirit and scope. Furthermore, all examples and conditional language recited herein are principally intended expressly to be only for pedagogical purposes and to aid the reader in understanding the principles and the concepts contributed by the inventors to furthering the art, and are to be construed as being without limitation to such specifically recited examples and conditions. Moreover, all statements herein reciting principles, aspects, and embodiments, as well as specific examples thereof, are intended to encompass both structural and functional equivalents thereof. Additionally, it is intended that such equivalents include both currently known equivalents and equivalents developed in the future, i.e., any elements developed that perform the same function, regardless of structure.

This description of the exemplary embodiments is intended to be read in connection with the figures of the accompanying drawing, which are to be considered part of the entire written description. In the description, relative terms concerning attachments, coupling and the like, such as "connected" and "interconnected," refer to a relationship wherein structures are secured or attached to one another either directly or indirectly through intervening structures, as well as both movable or rigid attachments or relationships, unless expressly described otherwise.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. An integrated circuit, comprising:
an external signal node connected to receive an injected current;
an output buffer comprising a first output stage connected between a first voltage supply and the external signal node; and
a current injection protection circuit comprising:
a first comparator configured to generate a first current injection control signal by comparing the first voltage supply to a first overvoltage signal generated from a voltage on the external signal node; and
a multiplex selection circuit comprising a first input connected to receive a first gate control signal that is generated from the first current injection control signal, a second input connected to receive a first pre-driver signal, and an output connected to a control gate terminal of the output buffer which clamps the external signal node to the first supply voltage if the voltage on the external signal node passes a trip threshold of the first comparator.

2. The integrated circuit of claim 1, further comprising an excursion limiter circuit connected to the external signal node to generate the first overvoltage signal.

3. The integrated circuit of any preceding claim, where the first comparator comprises an unbalanced back-to-back current mirror connected between the first voltage supply and an intermediate reference voltage between the first voltage supply and a second voltage supply.

4. The integrated circuit of any preceding claim, further comprising a pre-driver stack of transistors connected in a cascode configuration between the first voltage supply and a second voltage supply to receive the first current injection control signal and to generate the first gate control signal in response to the first current injection control signal.

5. The integrated circuit of claim 4, where the pre-driver stack of transistors comprises a diode-connected PFET device connected in series with one or more NFET devices between the first voltage supply and an intermediate reference voltage between the first voltage supply and a second voltage supply to generate the first gate control signal in response to a positive injected current at the external signal node.

6. The integrated circuit of claim 4 or 5, where the pre-driver stack of transistors comprises a diode-connected NFET device connected in series with one or more PFET devices between an intermediate reference voltage between the first voltage supply and a second voltage supply and the second supply voltage to generate the first gate control signal in response to a negative injected current at the external signal node.

7. The integrated circuit of any of claims 4 to 6, where the pre-driver stack of transistors comprises a first inverter connected between the first voltage supply and an intermediate reference voltage between the first voltage supply and a second voltage supply to generate the first gate control signal in response to a positive injected current at the external signal node.

8. The integrated circuit of any of claims 4 to 7, where the pre-driver stack of transistors comprises a second inverter connected between an intermediate reference voltage between the first voltage supply and a second voltage supply and the second supply voltage to generate the first gate control signal in response to a negative injected current at the external signal node.

9. A method for controlling I/O pad voltage excursions past a reference voltage that are caused by current injection fault, comprising:
selectively supplying a first pair of predriver gate control signals to an output buffer during normal operation, where the output buffer is connected to drive an I/O pad between a first reference voltage and a second reference voltage during normal operation;
detecting a current injection event which causes an I/O pad voltage excursion past either the first or second reference voltages;
selectively supplying a second pair of predriver gate control signals to the output buffer in response to the detected current injection event, where the output buffer is connected to clamp the I/O pad voltage to a first clamped voltage within approximately one volt of whichever of the first reference voltage or second reference voltage which experienced the I/O pad voltage excursion during the detected current injection event.

10. The method of claim 9, where one or more multiplexer selection circuits are connected and configured to selectively supply the first pair of predriver gate control signals to the output buffer during normal operation.

11. The method of claim 10, where the one or more multiplexer selection circuits are connected and configured to selectively supply the second pair of predriver gate control signals to the output buffer in response to the detected current injection event.

12. The method of any of claims 9 to 11, where a positive current injection comparator circuit is connected and configured to detect a positive current injection event which causes a positive I/O pad voltage excursion past a VDD reference voltage.

13. The method of claim 12, where the output buffer comprises a first PFET device connected in series with one or more additional PFET devices between the first reference voltage and the I/O pad, where the first PFET device is turned ON in response to the second pair of gate control signals to clamp the I/O pad voltage to the first clamped voltage when there is a positive I/O pad voltage excursion past the VDD reference voltage.

14. The method of any of claims 9 to 13, where a negative current injection comparator circuit is connected and configured to detect a negative current injection event which causes a negative I/O pad voltage excursion past a VSS reference voltage.

15. The method of claim 14, where the output buffer comprises a first NFET device connected in series with one or more NFET devices between the second reference voltage and the I/O pad, where the first NFET device is turned ON in response to the second pair of gate control signals to clamp the I/O pad voltage to the second clamped voltage when there is a negative I/O pad voltage excursion past the VSS reference voltage.
